Europäisches Patentamt

(19) European Patent Office

Office européen des brevets

(11) Veröffentlichungsnummer: **0 137 368**

A1

# (12) EUROPÄISCHE PATENTANMELDUNG

(21) Anmeldenummer: 84111176.8

(22) Anmeldetag: 19.09.84

(51) Int. Cl.⁴: **H 03 K 4/06**
G 06 G 7/26, H 03 B 27/00

(30) Priorität: 24.09.83 DE 3334592

(43) Veröffentlichungstag der Anmeldung:
17.04.85 Patentblatt 85/16

(84) Benannte Vertragsstaaten:
DE FR GB

(71) Anmelder: Nukem GmbH
Rodenbacher Chaussee 6 Postfach 11 00 80
D-6450 Hanau 11(DE)

(72) Erfinder: Quittkat, Jörg
Oberissigheimer Strasse 14
D-6451 Neuberg 1(DE)

(72) Erfinder: Thiel, Gerhard
Altvater Strasse 3
D-6463 Freigericht 1(DE)

(72) Erfinder: Ruth, Ursula
Gartenstrasse 13
D-6451 Ronneburg 1(DE)

(74) Vertreter: Stoffregen, Hans-Herbert, Dr.
Dipl.-Phys. et al,
Patentanwälte Strasse & Stoffregen Salzstrasse 11a
D-6450 Hanau/Main(DE)

(54) Funktionsgenerator.

(57) Ein durchstimmbarer Funktionsgenerator enthält einen ersten Funktionsgenerator (10) mit einem Dreieckspannungsgenerator, der einen Komparator (24) enthält, der die Umschaltung eines Kondensators (14) von einer Aufladephase auf eine Entladephase und umgekehrt in Abhängigkeit von einem oberen und unteren, vorab festgelegten Amplitudenwert der Spannung am Kondensator (14) steuert. Die am Kondensator (14) auftretende Dreieckspannung (50) wird in einem weiteren Dreieckspannungsgenerator einem zweiten Komparator (32) zugeführt. Der zweite Komparator (32) wird für die Umschaltung eines zweiten Kondensators (38) gleicher Kapazität von der Aufladephase auf die Entladephase und umgekehrt mit einer Referenzspannung beaufschlagt, die dem Mittelwert aus dem oberen und dem unteren Amplitudenwert entspricht. Die Aufladeströme und die Entladeströme sind gleich groß, konstant und zur Veränderung der Frequenz der Dreieckspannungen einstellbar. Den Kondensatoren (14, 38) sind Sinusfunktionsnetzwerke (30, 48) nachgeschaltet.

./...

Fig.1

NUKEM GmbH
Rodenbacher Chaussee 6
6450 Hanau/Main 11

Funktionsgenerator

Die Erfindung bezieht sich auf einen Funktionsgenerator mit einem Dreieckspannungsgenerator, der einen Komparator enthält, der die Umschaltung eines Kondensators von einer Aufladephase auf eine Entladephase und umgekehrt in Abhängigkeit von einem oberen und unteren, vorab festgelegten Amplitudenwert der Spannung am Kondensator steuert.

Ein derartiger Funktionsgenerator, der auch bei höheren Frequenzen noch einwandfrei arbeitet, ist aus dem Buch "Halbleiter-Schaltungstechnik" von U. Tietze, Ch. Schenk, 5. Auflage, Springer Verlag Berlin, Heidelberg, New York, 1980, Seite 443 bekannt. Dieser Funktionsgenerator wird zur Erzeugung einer Dreieckspannung und einer Rechteckspannung verwendet.

Aus dem gleichen Buch, Seiten 218, 219 ist die gleichzeitige Erzeugung einer sin- und cos-Funktion im Argumentbereich $-\pi \leq x \leq \pi$, d.h. über eine volle Periode, mittels Funktionsnetzwerken bekannt. Hierfür werden aus einer Eingangsspannung, die zwischen einem positiven und einem negativen Grenzwert verläuft, zwei Dreieckhilfsspannungen mittels Widerstandsnetzwerken und Komparatoren erzeugt. Die Dreieckhilfsspannungen werden Sinusfunktionsnetzwerken zugeführt.

Aus dem gleichen Buch Seiten 488 bis 490 aaO ist die Erzeugung von sin- und cos-Funktionen in digitaler Form bekannt. Die sin- und cos-Funktionswerte sind im Rahmen einer Tabelle in Nur-Lese-Speichern enthalten. Bei hoher Auflösung wird ein großer Speicherbedarf benötigt. Durch Interpolation zwischen gespeicherten Werten kann der Speicherbedarf vermindert werden. Durch den zusätzlichen Rechenaufwand wird aber die Zeit vergrößert, die bis zur Verfügbarkeit der Funktionswerte vergeht.

Schließlich ist es aus dem oben erwähnten Buch, Seiten 646 bis 649 bekannt, DA-Wandler für die Erzeugung von Sinusschwingungen einzusetzen. Als digitales Eingangssignal wird eine auf- und absteigende Zahlenfolge einem Analogmultiplexer zugeführt, dessen Gewichtung entsprechend eingestellt ist.

Der Erfindung liegt die Aufgabe zugrunde, einen Funktionsgenerator der eingangs beschriebenen Gattung derart weiterzuentwickeln, daß er zugleich eine fortlaufende Sinus- und Cosinusschwingung erzeugt, in einem weiten Bereich bis zu hohen Frequenzen durchstimmbar ist und auch beim schnellen Ändern der Frequenz der Schwingung keinen Amplituden- und Phasensprung aufweist.

Die Aufgabe wird erfindungsgemäß insbesondere durch die im Anspruch 1 beschriebenen Maßnahmen gelöst und zeichnet sich dadurch aus, daß die am Kondensator auftretende Dreieckspannung in einem weiteren Dreieckspannungsgenerator einem zweiten Komparator zuführbar ist, der für die Umschaltung eines zweiten Kondensators gleicher Kapazität von der Aufladephase auf die Entladephase und umgekehrt mit einer Referenzspannung beaufschlagt ist, die dem Mittelwert aus dem oberen und dem unteren Amplitudenwert entspricht, daß die Aufladeströme und die Entladeströme beider Kondensatoren gleich groß und einstellbar sind und daß den Kondensatoren jeweils ein Sinusfunktionsnetzwerk nachgeschaltet ist. Die im Anspruch 1 erläuterte Schaltungsanordnung arbeitet in einem sehr weiten Frequenzbereich, der

...

zwischen 100 Hz und einigen MHz liegt, genau. Durch den Wegfall des Amplituden- und Phasensprungs bei der Einstellung einer neuen Frequenz ergeben sich geringe Totzeiten. Das Prinzip der Erfindung besteht darin, mit einem ersten durchstimmbaren Funktionsgenerator, der bei Frequenzänderungen keinen Amplituden- und Phasensprung hat und eine Sinusschwingung abgibt, einen gleich aufgebauten zweiten Funktionsgenerator zwangsläufig mit einer Phasenverschiebung von 90° zu steuern.

Bei einer bevorzugten Ausführungsform ist vorgesehen, daß die Kondensatoren bei der Aufladung jeweils über ein erstes von den Komparatoren betätigbares Schaltelement an eine Konstantstromquelle und bei der Entladung jeweils über ein weiteres von den Komparatoren betätigbares Schaltelement auf eine Konstantstromquelle schaltbar sind. Diese Anordnung zeichnet sich durch ihren einfachen Aufbau aus.

Vorzugsweise sind zwischen den Kondensatoren und den Sinusfunktionsnetzwerken jeweils Spannungsfolger angeordnet. Damit wird die Belastung der Kondensatoren vermindert und die Genauigkeit der Anordnung erhöht.

Bei einer zweckmäßigen Ausführungsform sind die konstanten Ströme der Konstantstromquellen und Konstantstromsenken über eine Steuerspannung zugleich einstellbar, die den Konstantstromquellen und Konstantstromsenken über einen Spannungsfolger zuführbar ist. Mit dieser Anordnung läßt sich die Frequenz schnell und einfach einstellen.

Eine günstige Ausführungsform besteht darin, daß zwischen den Kondensatoren und den Sinusfunktionsnetzwerken jeweils Spannungsfolger angeordnet sind. Der Aufwand für die Erzeugung der Frequenzspannungen ist hierbei relativ gering.

...

Vorzugsweise wird der Funktionsgenerator zur Amplituden- und Phasenkompensation von Signalen verwendet, die von der Prüfspule eines Wirbelstromprüfgeräts erzeugt werden.

Die Erfindung wird im folgenden anhand eines in einer Zeichnung dargestellten Ausführungsbeispiels näher erläutert, aus dem sich weitere Einzelheiten, Merkmale und Vorteile ergeben.

Es zeigen:

Fig. 1 ein Schaltbild eines durchstimmbaren Funktionsgenerators für die Erzeugung einer fortlaufenden Sinus- und Cosinusschwingung,

Fig. 2 ein Zeitdiagramm von an verschiedenen Stellen der in Fig. 1 dargestellten Anordnung auftretenden Spannungen.

Ein durchstimmbarer Funktionsgenerator für die Erzeugung einer fortlaufenden Sinus- und Cosinusschwingung enthält einen ersten Funktionsgenerator 10 und einen zweiten Funktionsgenerator 12 für Dreieck- und Sinusspannungen. Im ersten Funktionsgenerator 10 ist ein Kondensator 14, dessen einer Anschluß an Erdpotential liegt, mit seinem zweiten Anschluß einerseits über ein Schaltelement 16 an eine Konstantstromquelle 20 und andererseits über ein Schaltelement 18 an eine Konstantstromsenke 22 angeschlossen. Der zweite Anschluß des Kondensators 14 ist weiterhin mit einem Eingang eines Komparators 24 und mit dem Eingang eines Spannungsfolgers 26 verbunden. Der invertierte Ausgang des Komparators 24 steuert das Schaltelement 16 und einen Umschalter 28, an dessen beiden Eingängen jeweils eine positive und eine betragsmäßig gleich große negative Referenzspannung anstehen. Der Ausgang des Umschalters 28 ist mit dem zweiten Eingang des Komparators 24 verbunden. Dem Ausgang des Spannungsfolgers 26 ist ein Sinusfunktionsnetzwerk 30 nachgeschaltet.

...

An den Ausgang des Spannungsfolgers 26 ist weiterhin der Eingang eines zweiten Komparators 32 angeschlossen, der Bestandteil des zweiten Funktionsgenerators 12 ist. Der Komparator 32 hat den gleichen Aufbau wie der Komparator 24. Der zweite Eingang des Komparators 32 ist an Erdpotential gelegt. Der invertierende Ausgang des Komparators 32 steuert ein Schaltelement 34, das zwischen einer Konstantstromquelle 36 und dem einen Anschluß eines Kondensators 38 angeordnet ist, dessen anderer Anschluß an Erdpotential gelegt ist. Der Kondensator 38 ist weiterhin über ein Schaltelement 16 mit einer Konstantstromsenke 17 verbunden. Mit dem Kondensator 15 steht ferner der Eingang eines Spannungsfolgers 44 in Verbindung, dem ein Sinusfunktionsnetzwerk 48 nachgeschaltet ist.

Die Konstantstromquelle 36 entspricht im Aufbau der Konstantstromquelle 20. Ebenso gleichen sich die Konstantstromsenken 22 und 42 im Aufbau. Die Kondensatoren 14 und 38 haben gleiche Kapazitäten. Das Schaltelement 40 wird vom nicht invertierenden Ausgang des Komparators 32 gesteuert. Die Spannungsfolger 26, 44 sind ebenfalls gleich aufgebaut. Auch die Sinusfunktionsnetzwerke 30, 48 stimmen im Aufbau miteinander überein.

Die Konstantstromquellen 20, 36 und die Konstantstromsenken 22, 42 erzeugen gleich große Konstantströme und sind einstellbar ausgebildet. Bis auf die Referenzspannungen an den zweiten Eingängen der Komparatoren 24, 32 stimmen die Funktionsgeneratoren 10 und 12 somit überein.

Die von den Konstantstromquellen 20, 36 und den Konstantstromsenken 20, 42 erzeugten Konstantströme werden mittels eines Spannungsfolgers 46 eingestellt, der ausgangsseitig mit den Konstantstromquellen 20, 36 und den Konstantstromsenken 22, 42 verbunden ist. Eingangsseitig wird der Spannungsfolger 46 von einer Steuerspannung beaufschlagt, deren Höhe die Höhe der Konstantströme bestimmt.

...

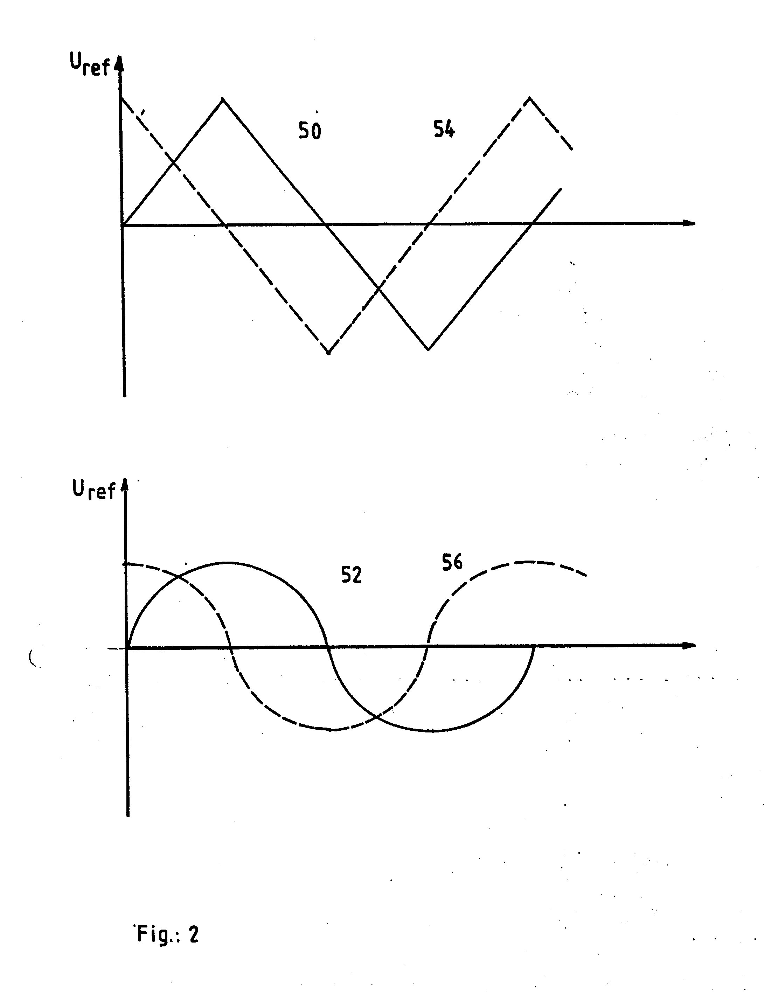

Der Kondenstor 14 wird abwechselnd über die Konstantstromquelle 20 aufgeladen und über die Konstantstromsenke 22 entladen. Wegen der Aufladung und Entladung mit Konstantströmen tritt am Kondensator 14 ein linearer Spannungsverlauf auf. Der Komparator 24 öffnet dann, wenn die Spannung am Kondensator 14 einen Wert erreicht, der der positiven Referenzspannung entspricht, das Schaltelement 16 und schließt das Schaltelement 18. Hierauf wird der Kondensator 14 entladen, wobei sich aufgrund des konstanten Entladestroms ein linearer Verlauf der Kondensatorspannung ergibt. Erreicht die Kondensatorspannung einen Wert, der der unteren Referenzspannung entspricht, dann öffnet der Komparator 24 das Schaltelement 18 und schließt das Schaltelement 16. Anschließend wiederholt sich der oben beschriebene Vorgang. Am Kondensator 14 tritt dabei eine Dreieckspannung auf, die in Fig. 2 mit 50 bezeichnet ist. In dem Diagramm gemäß Fig. 2 ist in Ordinatenrichtung die Spannung und in Abszissenrichtung die Zeit t aufgetragen.

Die obere Referenzspannung ist in Fig. 2 mit $+U_{Ref}$ und die untere Referenzspannung mit $-U_{Ref}$ bezeichnet. Die Dreieckspannung 50 verläuft zwischen den Grenzen $+U_{Ref}$ und $-U_{Ref}$. Der Spannungshub am Kondensator 14 ist dann wie folgt:

$$U = U_{Ref} + U_{Ref} = 2U_{Ref}.$$

Die Kapazität des Kondensators 14 sei C. Mit dem Konstantstrom I gibt dann folgende Beziehung:

$$C \cdot U = I \cdot T$$

worin T die Ladezeit des Kondensators 14 ist. Die Ladezeit entspricht einer halben Periode der Dreieckspannung 50. Da C und U konstant sind, ergibt sich folgende Beziehung zwischen I und T:

...

$$1 \sim \frac{1}{T} \quad \text{oder}$$

$$1 \sim f,$$

wobei f die Frequenz der Dreieckspannung bedeutet.

Der Konstantstrom ist somit der Frequenz der Dreieckspannung proportional. Durch die Einstellung eines entsprechenden Konstantstroms kann daher die Freuquenz der Dreieckspannung geändert werden.

Das Sinusfunktionsnetzwerk 30 erzeugt aus der Dreieckspannung eine Sinusschwingung, die in Fig. 2 mit 52 bezeichnet ist.

Wenn die Dreieckspannung 50 den Wert null hat, spricht der Komparator 32 an und schaltet abwechselnd das Schaltelement 34 und und zugleich das Schaltelement 40 aus bzw. das Schaltelement 34 aus und das Schaltelement 40 ein.

Damit ergibt sich am Kondensator 38 eine Dreieckspannung 54, die die gleichen Amplituden und die gleiche Frequenz hat wie die Dreieckspannung 50, jedoch dieser gegenüber um 90° phasenverschoben ist. Die gleichen Amplituden werden aufgrund der gleichen Konstantströme bei der Aufladung und der Entladung des Kondensators 38 erzeugt. Die gleiche Frequenz entsteht wegen der gleich großen Zeitabstände zwischen den Betätigungen der Schaltelemente 16, 18 und der Schaltelement 34, 40. Das Sinusfunktionsnetzwerk 48 formt die Dreieckspannung 54, die in Fig. 2 gestrichelt dargestellt ist, in eine Sinusschwingung 56 um, die in Fig. 2 ebenfalls gestrichelt dargestellt ist. Aufgrund der 90° Voreilung der Dreieckspannung 54 gegenüber der Dreieckspannung 50 stellt die Schwingung 56 eine Cosinus- und die Schwingung 52 die dazugehörige Sinusschwingung dar.

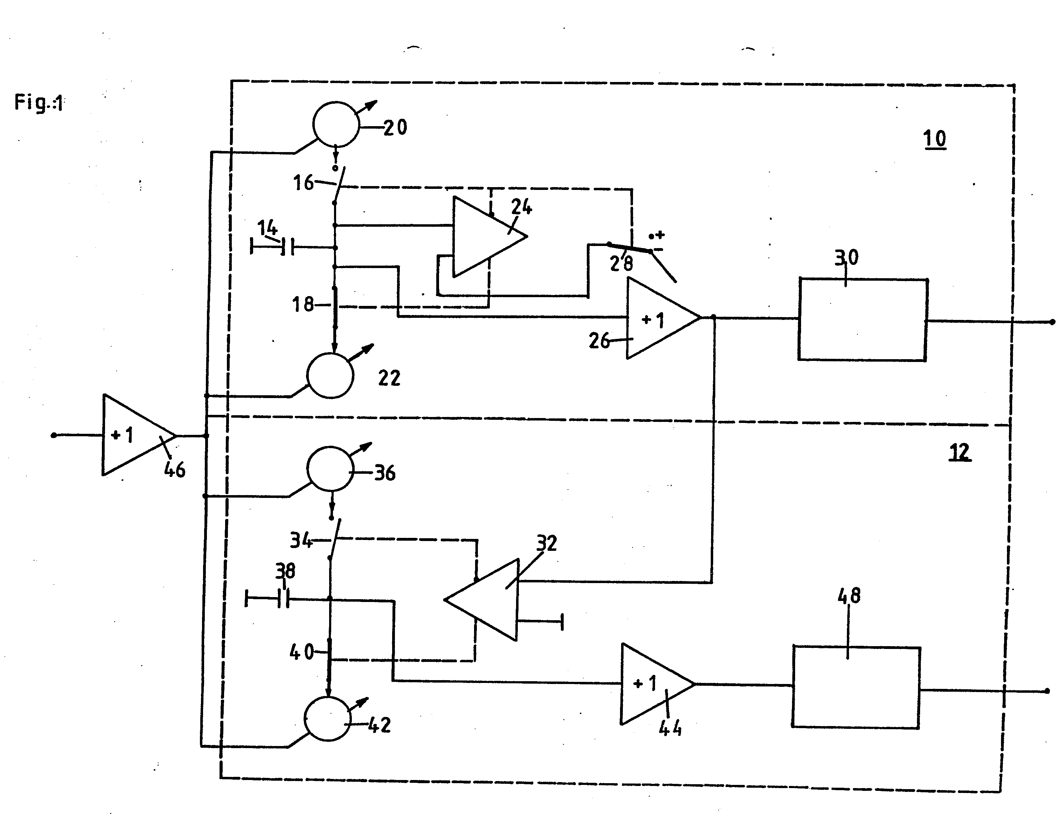

Die in Fig. 1 dargestellte Schaltungsanordnung arbeitet in einem sehr weiten Frequenzbereich, der zum Beispiel zwischen 100 Hz und 5 MHz liegt, einwandfrei und genau. Beim Verändern der Schwingungsfrequenz durch eine entsprechende Änderung des Stroms I treten keine Amplituden- und Phasensprünge auf. Es steht zugleich eine Sinus- und Cosinusschwingung zur Verfügung. Die Schaltung eignet sich deshalb besonders gut für die Amplituden- und Phasenkompensation von Signalen, die bei der Wirbelstromprüfung von Werkstücken empfangen werden.

– – – – – – – – – – –

NUKEM GmbH
Rodenbacher Chaussee 6
6450 Hanau/Main 11

Patentansprüche:

1. Funktionsgenerator mit einem Dreieckspannungsgenerator, der einen Komparator aufweist, der die Umschaltung eines Kondensators von einer Aufladephase auf eine Entladephase und umgekehrt in Abhängigkeit von einem oberen und unteren, vorab festgelegten Amplitudenwert der Spannung am Kondensator steuert, d a d u r c h   g e k e n n z e i c h n e t , daß die am Kondensator (14) auftretende Dreieckspannung (50) in einem weiteren Dreieckspannungsgenerator einem zweiten Komparator (32) zuführbar ist, der für die Umschaltung eines zweiten Kondensators (38) gleicher Kapazität von der Aufladephase auf die Entladephase und umgekehrt mit einer Referenzspannung beaufschlagt ist, die dem Mittelwert aus dem oberen und dem unteren Amplitudenwert entspricht, daß die Aufladeströme und die Entladeströme beider Kondensatoren (14, 38) gleich groß und einstellbar sind und daß den Kondensatoren (14, 38) jeweils ein Sinusfunktionsnetzwerk (30, 48) nachgeschaltet ist.

2. Funktionsgenerator nach Anspruch 1, d a d u r c h   g e k e n n z e i c h n e t , daß die Kondensatoren (14, 38) bei der Aufladung jeweils über ein erstes von den Komparatoren (24, 32) betätigbares Schalt-

...

element (16, 34) an eine Konstantstromquelle (20, 36) und bei der Entladung jeweils über ein weiteres von den Komparatoren betätigbares Schaltelement (18, 40) auf eine Konstantstromsenke (22, 42) schaltbar sind.

3. Funktionsgenerator nach Anspruch 2,
   d a d u r c h   g e k e n n z e i c h n e t,
   daß die Schaltelemente (16, 34) für die Aufladung und die Schaltelemente (18, 40) für die Entladung   jeweils zur gleichen Zeit ein- bzw. ausgeschaltet oder aus- bzw. eingeschaltet sind.

4. Funktionsgenerator nach einem der vorausgehenden Ansprüche,
   d a d u r c h   g e k e n n z e i c h n e t,
   daß der zweite Eingang des ersten Komparators (24) abwechselnd an eine positive und an eine gleich große negative Referenzspannung ($+U_{Ref}$, $-U_{Ref}$) anlegbar ist und daß der zweite Eingang des zweiten Komparators (32) an Erdpotential gelegt ist.

5. Funktionsgenerator nach einem der vorausgehenden Ansprüche,
   d a d u r c h   g e k e n n z e i c h n e t,
   daß zwischen den Kondensatoren (14, 38) und den Sinusfunktionsnetzwerken (30, 48) jeweils Spannungsfolger (26, 44) angeordnet sind.

6. Funktionsgenerator nach einem der vorausgehenden Ansprüche,
   d a d u r c h   g e k e n n z e i c h n e t,
   daß die konstanten Ströme (I) der Konstantstromquellen (20, 36) und Konstantstromsenken (22, 42) über eine Steuerspannung zugleich einstellbar sind, die den Konstantstromquellen (20, 36) und den Konstantstromsenken (22, 42) über einen Spannungsfolger (46) zuführbar ist.

7. Funktionsgenerator nach einem der vorausgehenden Ansprüche,
   d a d u r c h   g e k e n n z e i c h n e t,
   daß der zweite Eingang des ersten Komparators (24) über einen

...

von einem Ausgang des Komparators (24) betätigbaren Umschalter (28) abwechselnd an die beiden Referenzspannungen (+U$_{ref}$, -U$_{Ref}$) gelegt ist.

8.   Funktionsgenerator nach einem der vorausgehenden Ansprüche, g e k e n n z e i c h n e t   d u r c h die Verwendung zur Amplituden- und Phasenkompensation von Signalen, die von der Prüfspule eines Wirbelstromprüfgerätes erzeugt werden.

- - - - - - - - - -

Fig.1

1/2

0137368

Fig.: 2

Europäisches
Patentamt

**EUROPÄISCHER RECHERCHENBERICHT**

EP 84 11 1176

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ELECTRONICS INTERNATIONAL, Band 55, Nr. 9, 5. Mai 1982, New York, USA; R. RIEDEL et al. "Function generator lets users build waveforms of varying shape", Seiten 143-147 * Figur 2 * | 1,5 | H 03 K .4/06<br>G 06 G 7/26<br>H 03 B 27/00 |
| | --- | | |
| A | US-A-3 676 698 (L.W. HUNTER) * Figur 1 * | 1,5 | |
| | --- | | |
| A | GB-A-2 102 231 (TEKTRONIX INC.) * Figur 2; Spalte 2, Zeilen 76-81 * | 1,4,7 | |
| | --- | | |
| A | DE-B-2 426 394 (RCA CORP.) * Figur 1 * | 1,4,7 | |
| | | | RECHERCHIERTE SACHGEBIETE (Int. Cl.4) |
| A | US-A-4 016 498 (F. HADLEY) * Figuren 1,2 * | 1,6 | |
| | --- | | G 06 G 7/26<br>H 03 B 5/24<br>H 03 B 27/00<br>H 03 K 3/023<br>H 03 K 4/00<br>H 03 K 4/06 |
| A | ELECTRONICS INTERNATIONAL; Band 51, Nr. 24, 23. Noevember 1978, New York, USA; J.R. PIMENTEL "One-chip oscillator generates in-quadrature waveforms", Seite 147 | | |
| | ---          -/- | | |

Der vorliegende Recherchenbericht wurde für alle Patentansprüche erstellt.

| Recherchenort<br>BERLIN | Abschlußdatum der Recherche<br>07-12-1984 | Prüfer<br>ARENDT M |
|---|---|---|

**0137368**

Nummer der Anmeldung

EP  84 11 1176

# EUROPÄISCHER RECHERCHENBERICHT

Europäisches
Patentamt

Seite 2

| | EINSCHLÄGIGE DOKUMENTE | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
| D,A | U. TIETZE et al. "Halbleiter-Schaltungstechnik", 5. Auflage 1980, SPRINGER-VERLAG, Berlin Heidelberg, New York, Seiten 218, 219, 443, 488-490, 646-649 ----- | | |
| | | | **RECHERCHIERTE SACHGEBIETE (Int. Cl.4)** |

Der vorliegende Recherchenbericht wurde für alle Patentansprüche erstellt.

| Recherchenort BERLIN | Abschlußdatum der Recherche 07-12-1984 | Prüfer ARENDT M |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein- stimmendes Dokument

EPA Form 1503. 03.82